# EUROPÄISCHE PATENTANMELDUNG

(11) **EP 3 868 917 A1**
(43) Veröffentlichungstag der Anmeldung: **25.08.2021**
(21) Anmeldenummer: 20215266.6
(22) Anmeldetag: 16.06.2016
(51) Int. Cl.: C23C 14/35, C23C 14/50, H01J 37/34, G02B 1/10, B29D 11/00, H01J 37/32, C23C 14/34

(54) **VORRICHTUNG, VERFAHREN UND VERWENDUNG ZUR BESCHICHTUNG VON LINSEN**

(30) Priorität: 16.06.2015 EP 15001772; 17.06.2015 EP 15001787; 08.09.2015 EP 15020153
(62) Teilanmeldung aus: 16730695.0
(71) Anmelder: Schneider GmbH & Co. KG, 35112 Fronhausen (DE)
(72) Erfinder: SCHNEIDER, Gunter, 35037 Marburg (DE); HUTTENHUIS, Stephan, 35096 Niederweimar (DE); FUHR, Markus, 63526 Erlensee (DE)
(74) Vertreter: Von Rohr Patentanwälte Partnerschaft mbB

(57) **Zusammenfassung**

Es werden eine Vorrichtung, ein Verfahren und eine Verwendung zur Beschichtung von Linsen vorgeschlagen, wobei die zu beschichtenden Linsen paarweise über parallelen, rohrförmigen Targets derart angeordnet werden, dass diese jeweils sowohl einen homogenen als auch einen inhomogenen Abtragungsbereich des Targets überdecken und wobei die Linsen rotieren, so dass eine besonders gleichmäßige Beschichtung erreichbar ist.

## Beschreibung

Die vorliegende Erfindung betrifft eine Vorrichtung zur Beschichtung von Linsen gemäß dem Oberbegriff des Anspruchs 1, ein Verfahren zur Beschichtung von Linsen gemäß dem Oberbegriff des Anspruchs 16 sowie eine Verwendung eines rohrförmigen Targets zur Beschichtung von Linsen gemäß dem Oberbegriff des Anspruchs 18 oder 20.

Die vorliegende Erfindung betrifft generell das Beschichten von Linsen durch Sputtern, welches auch Kathodenzerstäubung genannt wird. Hierbei werden Atome aus einem Festkörper, dem sogenannten Target, durch Auftreffen von energiereichen Ionen herausgelöst und gehen in eine Gasphase über. Insbesondere betrifft die vorliegende Erfindung das sogenannte Magnetronsputtern, bei dem zusätzlich zu einem angelegten elektrischen Feld auch ein Magnetfeld hinter der Kathode bzw. dem Target angeordnet wird.

In der Praxis ist es schwierig, eine gleichmäßige Beschichtung der zu beschichtenden Linse zu erreichen, auch wenn aus dem Stand der Technik sind viele verschiedene Vorrichtungen und Verfahren zum Sputtern bekannt sind.

Die DE 40 10 495 C2 offenbart eine Vorrichtung zum Beschichten eines Substrats mit Werkstoffen durch Sputtern, wobei das Substrat um eine stationäre Achse drehbar ist und dem Substrat zwei Targets zugeordnet sind, die geneigt zu der Substratoberfläche gehalten sind. Hier ist eine gleichmäßige Beschichtung nicht oder allenfalls nur sehr schwierig erreichbar.

Die DE 295 05 497 U1 offenbart eine Beschichtungsstation zur Beschichtung von Linsen durch Sputtern, wobei die Linsen in einer Planetenanordnung über eine flächige Sputterquelle bewegt werden. Hier ist der bauliche Aufwand erheblich und die Beschickung der Beschichtungsstation mit zu beschichtenden Linsen aufwendig. Weiter ist eine optimale gleichmäßige Beschichtung nicht oder nur sehr schwierig erreichbar.

Die WO 03/023813 A1 offenbart eine Einrichtung zum Beschichten von Linsen durch Pulsmagnetron-Zerstäuben, wobei die Linsen linear entlang der Längserstreckung von zwei rohrförmigen, parallel verlaufenden Targets linear bewegt werden und dabei auch rotieren. Hier ist eine gleichmäßige Beschichtung der Linsen nicht oder allenfalls nur sehr schwierig erreichbar.

Der vorliegenden Erfindung liegt die Aufgabe zugrunde, eine Vorrichtung, ein Verfahren und eine Verwendung zur Beschichtung von Linsen anzugeben, wobei eine sehr gleichmäßige Beschichtung insbesondere von gekrümmten Oberflächen der Linsen bei einfachem Aufbau und/oder bei einfacher Beschickung ermöglicht wird.

Die obige Aufgabe wird durch eine Vorrichtung gemäß Anspruch 1, ein Verfahren gemäß Anspruch 16 oder eine Verwendung gemäß Anspruch 18 oder 20 gelöst. Vorteilhafte Weiterbildungen sind Gegenstand der Unteransprüche.

Gemäß einem Aspekt der vorliegenden Erfindung weist die Vorrichtung vorzugsweise ein längliches oder rohrförmiges Target auf und ist die zu beschichtende Linse um eine relativ zu dem Target stationäre Achse rotierbar. Insbesondere ist die Linse hierbei nicht linear bewegbar, sondern es handelt sich vorzugsweise um eine stationäre Anordnung, wobei das Target und die Linse vorzugsweise um jeweils stationäre Achsen rotieren. So kann bei geringem baulichen Aufwand eine besonders gleichmäßige Beschichtung der Linse erreicht werden.

Gemäß einem anderen Aspekt der vorliegenden Erfindung wird die zu beschichtende Linse vorzugsweise sowohl in einem ersten, zumindest im Wesentlichen homogenen Bereich als auch in einem zweiten, inhomogenen Bereich eines Ratenprofils der Abtragung eines Targets über dem Target gehalten und dabei rotiert. Somit wird eine besonders gleichmäßige Beschichtung insbesondere einer gekrümmten Oberfläche der Linse ermöglicht.

Insbesondere wird die zu beschichtende Linse in einem Endbereich oder dessen Nähe über dem vorzugsweise länglichen oder rohrförmigen Target gehalten. So kann eine besonders gute Ausnutzung der gerade zum Ende des Targets hin erhöhten Abgaberate und damit eine verbesserte Ausnutzung des zerstäubten Targetmaterials erfolgen.

Gemäß einem anderen Aspekt der vorliegenden Erfindung werden vorzugsweise zwei längliche bzw. rohrförmige, insbesondere parallele Targets zur Beschichtung von gekrümmten Oberflächen von Linsen eingesetzt, wobei die Linsen paarweise über den Targets angeordnet werden und vorzugsweise jeweils um eine stationäre Achse rotieren. Dies ermöglicht einen einfachen, kompakten Aufbau, wobei sehr gleichmäßige Beschichtungen der Linsen erreichbar sind.

Gemäß einem anderen Aspekt der vorliegenden Erfindung weist die Vorrichtung vorzugsweise einen Träger auf, der zusammen mit mindestens zwei Linsen wechselbar ist. Dies ermöglicht eine sehr einfache und schnelle Beschickung der Vorrichtung.

Gemäß einem weiteren, ebenfalls unabhängig realisierbaren Aspekt der vorliegenden Erfindung wird vorzugsweise ein Target mit einem über seine axiale Erstreckung bzw. Längserstreckung variierenden Außendurchmesser zur Beschichtung einer Linse eingesetzt. So kann insbesondere das Ratenprofil beeinflusst, insbesondere vergleichmäßigt, und/oder insbesondere eine sehr gleichmäßige bzw. gleichmäßigere Beschichtung auf der Linse oder ein sonstiger Beschichtungsverlauf auf der Linse erreicht oder erleichtert werden.

Die vorgenannten Aspekte sowie die sich aus der weiteren Beschreibung ergebenden Merkmale und Aspekte der vorliegenden Erfindung können unabhängig voneinander, aber auch in beliebiger Kombination realisiert werden.

Weitere Aspekte, Vorteile und Merkmale der vorliegenden Erfindung ergeben sich aus den Ansprüchen und der folgenden Beschreibung eines bevorzugten Ausführungsbeispiels anhand der Zeichnung. Es zeigt:
- Fig. 1: einen schematischen Schnitt einer vorschlagsgemäßen Vorrichtung zur Beschichtung von Linsen;
- Fig. 2: eine schematische Draufsicht der Vorrichtung;
- Fig. 3: eine schematische Seitenansicht der Vorrichtung mit einem schematisch angedeuteten Ratenprofil; und
- Fig. 4: eine schematische Draufsicht der Vorrichtung entsprechend Fig. 2, jedoch mit alternativ angeordneten Linsen.

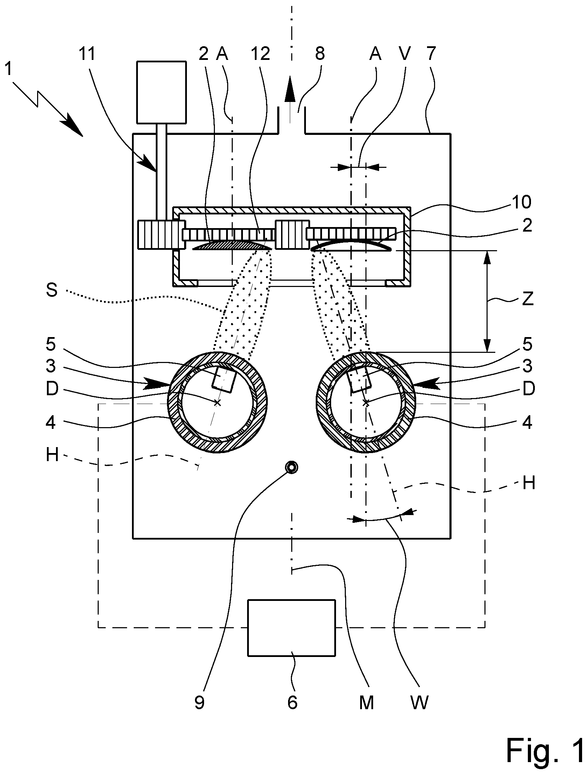

Fig. 1 zeigt in einem sehr schematischen Schnitt eine vorschlagsgemäße Vorrichtung 1 zur Beschichtung von Linsen 2, vorzugsweise optischen bzw. ophthalmischen Linsen bzw. Brillengläsern, insbesondere aus Kunststoff.

Die Vorrichtung 1 ist insbesondere zum Beschichten der Linsen 2 durch Sputtern, auch Kathodenzerstäubung genannt, ausgebildet. Besonders bevorzugt erfolgt ein sogenanntes Magnetronsputtern. Zusätzlich zu einem elektrisch angelegten Feld wird hierbei auch ein Magnetfeld benutzt bzw. angelegt, worauf später noch etwas näher eingegangen wird.

Besonders bevorzugt werden gekrümmte, insbesondere konkave Oberflächen der Linsen 2 erfindungsgemäß beschichtet. In Fig. 1 ist schematisch bei der auf der rechten Seite dargestellten Linse 2 eine solche gekrümmte Oberfläche angedeutet. Jedoch können grundsätzlich auch konvexe Oberflächen oder sonstige Oberflächen der Linsen 2 entsprechend beschichtet werden.

Die Vorrichtung 1 weist mindestens eine Sputterquelle 3, hier vorzugsweise zwei Sputterquellen 3, auf.

Die Vorrichtung 1 bzw. die jeweilige Sputterquelle 3 weist ein Target 4 auf, dessen Material beim Beschichten bzw. Sputtern abgetragen wird und - insbesondere zusammen mit anderen Bestandteilen der Gasatmosphäre - die gewünschte Beschichtung auf der jeweiligen Linse 2 bzw. deren zu beschichtenden Oberfläche bildet.

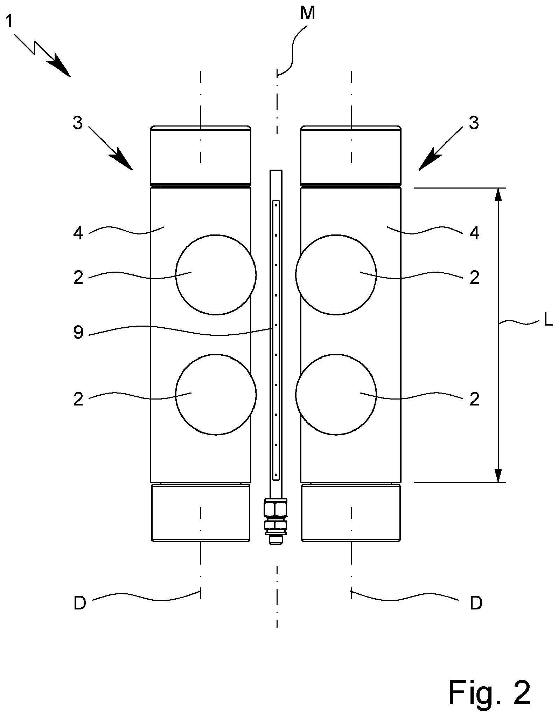

Fig. 2 zeigt die Vorrichtung 1 bzw. Sputterquellen 3 in einer schematischen Draufsicht.

Die Sputterquellen 3 bzw. Targets 4 sind beim Darstellungsbeispiel bevorzugt zumindest im Wesentlichen länglich bzw. rohrförmig oder zylindrisch ausgebildet.

Die Targets 4 sind insbesondere hohlzylindrisch bzw. rohrförmig ausgebildet.

Die Sputterquellen 3 bzw. Targets 4 sind vorzugsweise parallel zueinander angeordnet.

Vorzugsweise sind die Targets 4 drehbar bzw. rotierbar um Drehachsen D. Die Drehachsen D verlaufen vorzugsweise in einer gemeinsamen Ebene und/oder insbesondere parallel zueinander, wie in den Fig. 1 und 2 angedeutet, können alternativ aber auch zueinander geneigt sein. Die Drehachsen D entsprechen vorzugsweise den Längsachsen der Sputterquellen 3.

Besonders bevorzugt sind die Sputterquellen 3 bzw. Targets 4 baugleich und/oder identisch aufgebaut, so dass nachfolgend primär nur auf den Aufbau einer Sputterquelle 3 bzw. eines Targets 4 eingegangen wird. Jedoch können die Sputterquellen 3 bzw. Targets 4 auch grundsätzlich unterschiedlich ausgebildet sein.

Die Sputterquelle 3 weist vorzugsweise eine Magnetanordnung 5 auf, die dem jeweiligen Target 4 zur Erzeugung des bereits genannten Magnetfelds und damit einer gerichteten Sputterwolke S zugeordnet ist, wie in Fig. 1 schematisch angedeutet. Insbesondere ist die Magnetanordnung 5 unter bzw. in dem jeweiligen Target 4 angeordnet.

Die Vorrichtung 1 weist eine Spannungsquelle 6 auf, wie in Fig. 1 angedeutet, um die Sputterquellen 3 bzw. Targets 4 - insbesondere abwechselnd - als Kathode betreiben bzw. zum Sputtern mit der erforderlichen Spannung, insbesondere in Form von Pulsen, beaufschlagen zu können.

Besonders bevorzugt werden die Sputterquellen 3 bzw. Targets 4 abwechselnd mit Gleichstrom (Pulsen) betrieben bzw. beaufschlagt. Dies wird auch als "Bi-polar DC" bezeichnet. Abwechselnd dient dann eine Sputterquelle 3 bzw. ein Target 4 als Kathode und die andere Sputterquelle 3 bzw. das andere Target 4 als Anode.

Alternativ kann ein Betrieb mit Wechselstrom oder ein sonstiger Betrieb erfolgen.

Alternativ oder zusätzlich können auch eine oder mehrere zusätzliche oder separate Anoden eingesetzt werden, auch wenn dies nicht bevorzugt ist.

Die Vorrichtung 1 weist vorzugsweise eine Beschichtungskammer 7 auf, in der die Beschichtung erfolgt bzw. die Sputterquellen 3 angeordnet sind.

Das bevorzugte abwechselnde Betreiben der Sputterquellen 3 bzw. Targets 4 als Kathode und Anode führt dazu, dass keine gehäuseseitige oder feste Gegenelektrode erforderlich ist. Insbesondere wird die Beschichtungskammer 7 nicht als Gegenelektrode eingesetzt. Hierdurch lässt sich eine unerwünschte Verschmutzung bzw. Ablagerung von Targetmaterial auf der Gegenelektrode minimieren bzw. ein besonders stabiles Verfahren oder Beschichten auch unabhängig von einer Verschmutzung der Beschichtungskammer 7 erreichen. Dementsprechend können hierdurch erforderliche Reinigungen und Wartungen reduziert werden.

Weiter können die Targets 4 sehr leicht gewechselt werden. Auch dies erleichtert den Service.

Die Beschichtungskammer 7 ist insbesondere mittels einer hier nur schematisch angedeuteten Einrichtung 8, wie einem Anschluss, einer Vakuumpumpe o. dgl., in gewünschter Weise evakuierbar.

Die Vorrichtung 1 bzw. Beschichtungskammer 7 weist vorzugsweise eine schematisch angedeutete Gaszuführung 9, insbesondere in Form einer sich in den Beschichtungsraum erstreckenden Gaslanze, auf.

Die Vorrichtung 1 weist vorzugsweise einen Träger 10 zur Halterung der Linsen 2 auf, wie in Fig. 1 angedeutet.

In Fig. 2 und in weiteren Figuren ist der Träger 10 aus Veranschaulichungsgründen nicht dargestellt.

Die zu beschichtenden Linsen 2 sind vorzugsweise jeweils um eine Achse A drehbar bzw. rotierbar. Die Vorrichtung 1 bzw. der Träger 10 ist zur entsprechenden drehbaren Halterung und insbesondere zum entsprechenden Antreiben der Linsen 2 ausgebildet. Insbesondere weist die Vorrichtung 1 einen entsprechenden, in Fig. 1 nur schematisch angedeuteten Drehantrieb 11 auf, vorzugsweise um alle Linsen 2 des Trägers 10 gemeinsam anzutreiben.

Der Träger 10 ist vorzugsweise zusammen mit mindestens zwei Linsen 2 bzw. allen Linsen 2 bzw. hier vier Linsen 2, die gleichzeitig in der Vorrichtung 1 bzw. Beschichtungskammer 7 beschichtet werden, wechselbar.

Insbesondere hält der Träger 10 die Linsen 2 - insbesondere um eigene bzw. unterschiedliche Achsen A - drehbar, besonders bevorzugt drehbar gekoppelt. Besonders bevorzugt weist der Träger 10 eine Drehkopplung 12, beispielsweise über ein entsprechendes Getriebe, auf, wie in Fig. 1 schematisch angedeutet.

Vorzugsweise wird der Träger 10 selbst während der Beschichtung nicht bewegt, sondern nur die davon gehaltenen Linsen 2 rotiert. Vorzugsweise ist der Träger 10 beim Einsetzen oder Einschieben in die Vorrichtung 1 bzw. Beschichtungskammer 7 automatisch antriebsmäßig oder getriebemäßig, insbesondere mit dem Drehantrieb 11 o. dgl. der Vorrichtung 1 koppelbar.

Der Träger 10 gestattet eine schnelle Beschickung der Vorrichtung 1 bzw. Beschichtungskammer 7 mit den zu beschichtenden Linsen 2 bzw. eine schnelle Entnahme der beschichteten Linsen 2.

Die Vorrichtung 1 bzw. Beschichtungskammer 7 ist vorzugsweise über eine nicht dargestellte Zugangsöffnung mit den zu beschichtenden Linsen 2 bzw. dem Träger 10 beschickbar. Die Zugangsöffnung ist vorzugsweise mittels des Trägers 10 oder durch einen nicht dargestellten Verschluss insbesondere gasdicht verschließbar.

Die Beschichtungskammer 7 ist zum Beschichten vorzugsweise gasdicht verschließbar.

Der Träger 10 ist vorzugsweise generell bei Vorrichtungen zur Beschichtung von Linsen 2 einsetzbar, insbesondere also auch bei anderen Beschichtungsverfahren als dem Sputtern.

Die Drehachsen D bzw. Längserstreckungen L der Targets 4 verlaufen vorzugsweise in einer gemeinsamen Ebene, besonders bevorzugt einer Horizontalebene.

Die Linsen 2 sind vorzugsweise oberhalb der vorgenannten Ebene angeordnet.

Vorzugsweise ist jede Linse 2 über einem zugeordneten Target 4 angeordnet. Der Begriff "über" kann sich auf die vertikale Höhe gegenüber dem zugeordneten Target 4 und/oder darauf beziehen, dass die zu beschichtende Oberfläche der Linse 2 wenigstens eine Flächennormale aufweist, die das Target 4 und besonders bevorzugt deren Drehachse D schneidet.

Vorzugsweise sind die Linsen 2 paarweise einer Sputterquelle 3 bzw. einem Target 4 zugeordnet.

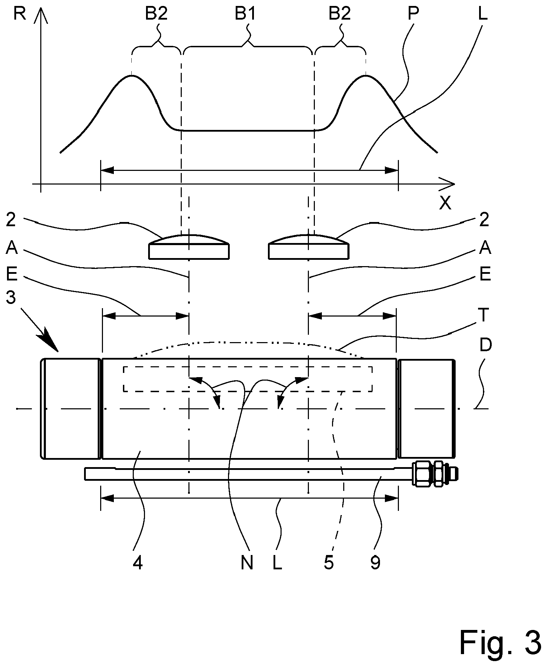

Insbesondere sind jeweils zwei Linsen 2 über einem gemeinsamen Target 4 angeordnet, wie in Fig. 2 und in der schematischen Seitenansicht gemäß Fig. 3 angedeutet.

Besonders bevorzugt ist die Vorrichtung 1 bzw. der Träger 10 zur Aufnahme von zwei Paaren von Linsen 2, also von insgesamt vier Linsen 2, ausgebildet, wobei jeweils zwei Linsen 2 einer gemeinsamen Sputterquelle 3 bzw. einem gemeinsamen Target 4 zugeordnet sind. Nachfolgend wird auf die bevorzugte Anordnung und Ausrichtung von einem solchen Paar von Linsen 2, die einem gemeinsamen Target 4 zugeordnet sind, näher eingegangen. Diese Ausführungen und Erläuterungen gelten insbesondere entsprechend für das andere Paar von Linsen 2, da die Vorrichtung 1 bzw. die Anordnung von Linsen 2 in der Vorrichtung 1 besonders bevorzugt weitestgehend symmetrisch bzgl. einer Mittelebene M - in den Figuren 1 und 2 der auf der Zeichnungsebene senkrecht stehenden Mittelebene M - ist.

Die einem gemeinsamen Target 4 zugordneten Linsen 2 sind vorzugsweise in einer Richtung parallel zur Längserstreckung L bzw. Drehachse D des Targets 4 versetzt angeordnet. Diese Richtung wird auch als X-Richtung bzw. X-Achse insbesondere bei dem in Fig. 3 schematisch angedeuteten Diagramm bezeichnet.

Die Linsen 2 bzw. deren Achsen A sind vorzugsweise symmetrisch bezüglich der Längserstreckung L des Targets 4 angeordnet und/oder weisen einen Versatz bzw. Abstand E vom jeweiligen Ende des Targets 4 in axialer Richtung bzw. X-Richtung auf.

Insbesondere sind die Linsen 2 in einem Endbereich oder dessen Nähe des jeweiligen Targets 4 angeordnet, wie in Fig. 1 und 2 angedeutet.

Das Diagramm in Fig. 3 veranschaulicht qualitativ die Rate R der Abtragung des Targets 4 bei der Beschichtung in Abhängigkeit von der axialen Position bzw. X-Position. So ergibt sich ein Ratenprofil P der Rate R über X, also in Richtung der Längserstreckung L des Targets 4.

Das Ratenprofil P weist im mittigen axialen Bereich des Targets 4 einen ersten, zumindest im Wesentlichen homogenen Bereich B1 auf. Die Rate R ist in dem ersten Bereich B1 also zumindest im Wesentlichen konstant bzw. variiert entlang der axialen Erstreckung des Targets 4 in diesem Bereich B1 allenfalls nur sehr gering, insbesondere weniger als 5%. Vorzugsweise ist "im wesentlichen konstant" erfindungsgemäß so zu verstehen, dass die Rate R entlang der Längserstreckung L - hier im Bereich B1 - um weniger als 5 % variiert.

Das Ratenprofil P weist weiter einen zweiten, nicht homogenen bzw. inhomogenen Bereich B2 auf. In diesem zweiten Bereich B2 variiert die Rate R sehr stark, steigt insbesondere zum Ende des Targets 4 hin stark an, besonders bevorzugt um mehr als 10%.

Die zum Ende des Targets 4 bzw. jeweiligen Magnetanordnung 5 hin ansteigende Rate R der Abtragung des Targets 4 im zweiten Bereich B2 lässt sich durch die im Endbereich erhöhte Magnetfeldstärke erklären.

Aus Fig. 3 ist ersichtlich, dass sich an den ersten Bereich B1 auf beiden Seiten bzw. zum jeweiligen Ende des Targets 4 hin jeweils ein zweiter Bereich B2 im genannten Sinn anschließt.

Die Linsen 2 sind vorzugsweise jeweils derart - hier in axialer Erstreckung L bzw. X-Richtung über den Target 4 - angeordnet, dass die Linse 2 jeweils sowohl in dem ersten Bereich B1 als auch in dem zweiten Bereich B2 angeordnet ist bzw. diese überdeckt. Besonders bevorzugt ist die Mitte bzw. Achse A der jeweiligen Linse 2 in der Nähe des Übergangs vom ersten Bereich B1 zum zweiten Bereich B2 angeordnet. Die Abweichung der Achse A von diesem Übergang beträgt vorzugsweise weniger als 30%, insbesondere weniger als 20%, besonders bevorzugt weniger als 10% des Linsendurchmessers.

Es hat sich gezeigt, dass durch die vorgenannte Anordnung der Linse 2 sowohl im ersten Bereich B1 als auch im zweiten Bereich B2 unter Berücksichtigung der Rotation der Linse 2 um die Achse A bei der Beschichtung eine besonders gleichmäßige Beschichtung erzielbar ist.

Die Achse A, um die die Linse 2 bei der Beschichtung jeweils rotiert, ist vorzugsweise relativ zu dem Target 4 bzw. der Sputterquelle 3 oder Drehachse D stationär bzw. fest.

Insbesondere wird eine lineare Bewegung bzw. eine Schwerpunktbewegung, wie eine Kreisbewegung, zwischen der Sputterquelle 3 bzw. des Targets 4 bzw. den Drehachsen D einerseits und der zu beschichtenden Linse 2 bzw. Linsen 2 bzw. Achsen A andererseits vermieden bzw. ausgeschlossen. Dies ist einem besonders einfachen Aufbau zuträglich.

Der Versatz bzw. Abstand E der Rotationsachse A der Linse 2 von dem jeweiligen Ende des Targets 4 beträgt vorzugsweise mehr als das 1,0-fache oder 1,5-fache des Linsendurchmessers und/oder Targetdurchmessers.

Der Abstand E ist vorzugsweise fest. Optional erfolgt eine Anpassung oder Verstellung des Abstands E der Rotationsachse A der Linse 2 von dem jeweiligen Ende des Targets 4 in Abhängigkeit von dem Durchmesser und/oder der Krümmung bzw. Form der zu beschichtenden Linse 2 bzw. Oberfläche.

Der (vertikale) Abstand Z der Linse 2 vom zugeordneten Target 4 ist in Fig. 1 angedeutet und beträgt vorzugsweise mehr als das 1,0-fache des Linsendurchmessers oder Targetdurchmessers.

Der (vertikale) Abstand Z der Linse 2 vom zugeordneten Target 4 beträgt vorzugsweise mehr als etwa 60 mm und/oder weniger als 150 mm, insbesondere weniger als 130 mm.

Der Abstand Z ist vorzugsweise fest. Optional erfolgt eine Anpassung oder Verstellung des (vertikalen) Abstands Z der Linse 2 vom zugeordneten Target 4 in Abhängigkeit von dem Durchmesser und/oder der Krümmung bzw. Form der zu beschichtenden Linse 2 bzw. Oberfläche.

Der Targetdurchmesser beträgt vorzugsweise etwa 70 bis 130 mm.

Vorzugsweise ist der Target(außen)durchmesser über die Länge zumindest im Wesentlichen konstant.

Das Target 4 ist vorzugsweise also zylindrisch bzw. hohlzylindrisch ausgebildet. Die Achsen A von zwei einem gemeinsamen Target 4 zugeordneten Linsen 2 verlaufen vorzugsweise in einer gemeinsamen Ebene und insbesondere parallel zueinander.

Die Achsen A verlaufen vorzugsweise quer oder senkrecht zu der Targetebene bzw. gemeinsamen Ebene der Drehachsen D bzw. zu der Drehachse D des zugeordneten Targets 4.

Die Achsen A können in ihrer gemeinsamen Ebene auch relativ zueinander, insbesondere aufeinander zu oder nach außen bzw. voneinander weg geneigt sein. Demensprechend sind die Linsen 2 dann mehr einander angenähert oder voneinander abgerückt, insbesondere ggf. so dass die zu beschichtenden Oberflächen der zwei Linsen 2 etwas zueinander hin verkippt werden bzw. etwas mehr zur Mitte des jeweiligen Targets 4 hin weisen. Dementsprechend kann der Neigungswinkel N der Achsen A zu den Drehachsen D von den bevorzugten 90°, wie in Fig. 3 dargestellt, abweichen und entweder weniger als 90°, beispielsweise etwa 70° bis 85°, oder mehr als 90°, beispielsweise etwa 95° bis 110°, betragen.

Der Neigungswinkel N ist vorzugsweise fest. Besonders bevorzugt erfolgt aber optional eine Anpassung oder Verstellung des Neigungswinkels N in Abhängigkeit von dem Durchmesser und/oder der Krümmung bzw. Form der zu beschichtenden Linse 2 bzw. Oberfläche.

Die Rotationsachse A der Linse 2 kann auch in Y-Richtung, also in einer Richtung quer zur Drehachse D in horizontaler Richtung bzw. zur Mitte zwischen den beiden Drehachsen D der Targets 4 hin verschoben sein, insbesondere so dass sich ein Versatz oder Abstand V zwischen der Linsenachse A und der zugeordneten Target achse D bildet, wie in Fig. 1 für die auf der rechten Seite angeordnete Linse 2 angedeutet (gleiches gilt vorzugsweise natürlich auch für die auf der linken Seite angeordnete Linse 2). Der Versatz bzw. Abstand V beträgt vorzugsweise weniger als 20%, insbesondere weniger als 10% des Linsendurchmessers und/oder Targetdurchmessers.

Der Abstand V ist vorzugsweise fest. Optional erfolgt eine Anpassung oder Verstellung des Abstands V zwischen der Linsenachse A und der zugeordneten Target achse D in Abhängigkeit von dem Durchmesser und/oder der Krümmung bzw. Form der zu beschichtenden Linse 2 bzw. Oberfläche.

Vorzugsweise werden der Neigungswinkel N und/oder die Lage der Achsen A bzw. die Abstände E, V und/oder Z durch den Träger 10 festgelegt.

Die Gaszuführung 9 ist vorzugsweise unterhalb der Sputterquellen 3 bzw. Targets 4 und/oder dazwischen, besonders bevorzugt in der Mittelebene M der Vorrichtung 1 bzw. Beschichtungskammer 7 angeordnet.

Die Gaszuführung 9 ist vorzugsweise rohrförmig und/oder stabartig ausgebildet und/oder mit vorzugsweise in einer Reihe angeordneten und/oder nach oben weisenden Gasauslässen versehen.

Die beim Beschichten auftretende Sputterwolke S, also das zerstäubte Targetmaterial, wird mittels des bereits genannten Magnetfelds bzw. der Magnetanordnung 5 jeweils zumindest im Wesentlichen in eine gewünschte Richtung gelenkt. Diese in Fig. 1 gestrichelt angedeutete Hauptrichtung H der Ausbreitung der Sputterwolke S ist durch entsprechende Anordnung bzw. Ausrichtung der Magnetanordnung 5 beeinflussbar, insbesondere festlegbar.

Beim Darstellungsbeispiel ist die Hauptrichtung H in der Schnittebene senkrecht zu den Drehachsen D und/oder der beiden Targets 4 vorzugsweise zueinander und/oder um den Winkel W (ausgehend von einer parallelen Ausrichtung) geneigt. Vorzugsweise ist der Winkel W einstellbar bzw. anpassbar, insbesondere durch entsprechende Verstellung oder Ansteuerung der Magnetanordnungen 5.

Der Winkel W beträgt vorzugsweise weniger als 10°, insbesondere weniger als 7°, besonders bevorzugt weniger als 5°.

Wie bereits angesprochen, können die Hauptrichtungen H der beiden Sputterwolken S auch parallel zueinander und/oder senkrecht zu der Erstreckungsebene der Targets 4 bzw. Ebene mit dem Drehachsen D verlaufen.

Vorzugsweise verlaufen die Hauptrichtungen H vertikal nach oben oder enthalten eine solche Richtungskomponente. Alternativ kommt eine horizontale Ausrichtung der Hauptrichtungen H vor. Die Anordnung der Linsen 2 und Sputterquellen 3 bzw. Targets 4 muss dann natürlich entsprechend gewählt werden.

Vorzugsweise werden die Linsen 2 bei der vorschlagsgemäßen Vorrichtung 1 und bei dem vorschlagsgemäßen Verfahren jeweils sowohl in dem ersten Bereich B1 als auch in dem zweiten Bereich B2 gehalten und dabei rotiert. Hierdurch ist eine besonders gleichmäßige Beschichtung erreichbar.

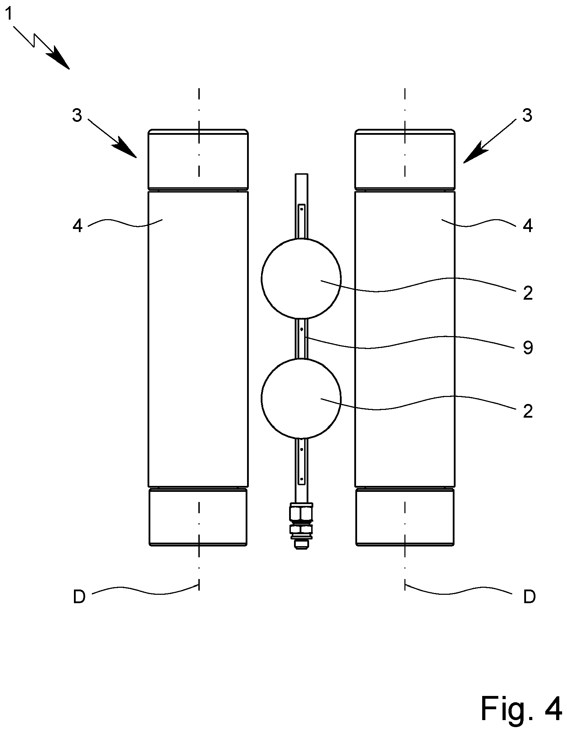

Besonders bevorzugt werden die Linsen 2 jeweils paarweise beschichtet, insbesondere werden jeweils gleichzeitig zwei Paare von Linsen 2 beschichtet. Grundsätzlich ist jedoch auch möglich, nur ein Paar von Linsen 2 in der Vorrichtung 1 vorschlagsgemäß zu beschichten. Hierzu werden die beiden Linsen dann vorzugsweise über einen gemeinsamen Taget 4 und/oder zwischen den beiden Targets 4, wie schematisch in Fig. 4 in einer alternativen Anordnung gezeigt, angeordnet.

Vorzugsweise wird das Ratenprofil P nicht durch Verteilungsblenden oder dergleichen in der Vorrichtung 1 bzw. Beschichtungskammer 7 beeinflusst oder homogenisiert. Dies ist insbesondere im Hinblick auf unerwünschte Abscheidungen auf derartigen Blenden vorteilhaft.

Gemäß einem auch unabhängig realisierbaren Aspekt der vorliegenden Erfindung kann der Außendurchmesser des Targets 4 über die axiale Erstreckung bzw. Länge oder Längserstreckung L des Targets 4 variieren, wie durch die zweipunktierte Strichlinie bzw. Targetoberfläche T in Fig. 3 schematisch angedeutet.

Insbesondere kann das Target 4 beispielsweise in der Mitte dicker als an den Endbereichen und/oder beispielsweise bauchig ausgebildet sein.

In der Mitte bzw. zwischen den Rotationsachsen A der Linsen 2 bzw. zwischen den (sich sonst bildenden) Bereichen B2 ist der Außendurchmesser des Targets 4 vorzugsweise zumindest im Wesentlichen konstant und/oder beispielsweise um mehr als 4 % größer als an den Enden des Targets 4, wie in Fig. 3 angedeutet.

Insbesondere kann der Außendurchmesser auch nur zu den Endbereichen des Targets 4 hin, insbesondere in den Bereichen B2 bzw. nur im Endbereich von weniger als 25 % der Länge L des Targets 4, jeweils reduziert sein bzw. abnehmen.

Grundsätzlich kann der Außendurchmesser in Längserstreckung L einen beliebigen Verlauf aufweisen, bedarfsweise auch (partiell) konvex, konkav oder gewellt.

Vorzugsweise variiert der Außendurchmesser des Targets 4 über die Längserstreckung bzw. Länge L des Targets 4 um mehr als 4 %.

Besonders bevorzugt wird das Ratenprofil P durch Variation des Außendurchmessers über die Länge L des Targets 4 in gewünschter Weise modifiziert, beispielsweise vergleichmäßigt.

Alternativ oder zusätzlich zu der Variation des Außendurchmessers kann auch das Magnetfeld bzw. die Magnetfeldstärke der Magnetanordnung 5 über die Länge L des Targets 4 bzw. der Sputterquelle 3 variieren, insbesondere zum Ende hin jeweils abnehmen und/oder im Bereich der Mitte größer sein, insbesondere um mehr als 4 %, um das Ratenprofil P in gewünschter Weise zu modifizieren, besonders bevorzugt zu vergleichmäßigen, und/oder um auch bei variierendem Außendurchmesser des Targets 4 eine bestimmte bzw. gewünschte und/oder zumindest im Wesentlichen konstante Stärke des Magnetfelds auf der Targetoberfläche, insbesondere auch unter Berücksichtigung des optional variierenden Außendurchmessers, zu erreichen.

Durch die vorgenannten Variationen von Außendurchmesser und/oder Magnetfeld wird das Ratenprofil P vorzugsweise derart vergleichmäßigt, modifiziert oder festgelegt, dass insbesondere unter Berücksichtigung der Positionierung der zu beschichtenden Linse 2 relativ zu dem Target 4 (beispielsweise der Lage der Rotationsachse A der Linse 2 und der Entfernung der Linse 2) und/oder unter Berücksichtigung der Form und/oder Größe der zu beschichtenden Oberfläche der Linse 2 eine gewünschte, insbesondere gleichmäßige oder in sonstiger Weise definierte, ggf. auch ungleichmäßige, beispielsweise zum Rand hin ansteigende oder abnehmende Beschichtung der Linse 2 erreichbar ist bzw. erreicht wird.

Die Linsen 2 rotieren vorzugsweise zentrisch um die jeweilige Achse A, insbesondere bezüglich der geometrischen Mitte der Linse 2.

Gemäß einer nicht dargestellten Ausführungsvariante können die Linsen 2 optional auch exzentrisch bezüglich der Rotationsachse A rotieren bzw. eingespannt sein. Die Exzentrität ist dabei vorzugsweise kleiner als der Radius der Linse 2, kann ggf. auch größer sein.

Insbesondere schneidet die Rotationsachse A also die jeweilige Linse 2.

Die Achse A verläuft vorzugsweise senkrecht zur Hauptebene der jeweiligen Linse 2.

Jede der Linsen 2 ist vorzugsweise um eine eigene Achse A rotierbar.

Die Achse A verläuft vorzugsweise quer, optional senkrecht, zu der Längserstreckung bzw. Drehachse D des zugeordneten Targets 4.

Insbesondere schneidet die Rotationsachse A der jeweiligen Linse 2 das zugeordnete Target 4, wie in Fig. 1 angedeutet, oder optional die Längs- bzw. Drehachse D des zugeordneten Targets 4.

Die Linse 2 weist während des Beschichtens bzw. Rotierens mit ihrer zu beschichtenden Seite vorzugsweise immer zu dem zugeordneten Target 4 bzw. den beiden zugeordneten Targets 4.

Vorzugsweise verläuft die Drehachse D des jeweiligen Targets 4 senkrecht zu einer beliebigen bzw. mindestens einer Flächennormalen der zu beschichtenden Linse 2 bzw. Oberfläche.

Die Flächennormale des optischen oder geometrischen Zentrums der Linse 2 kann zur Rotationsachse A bzw. Drehachse D geneigt sein.

Die Linsenzentren sind vorzugsweise symmetrisch zum jeweiligen Target 4 in X-Richtung bzw. Längserstreckung des Targets 4 angeordnet.

Die zu beschichtenden Linsen 2 bzw. deren geometrische oder optische Zentren sind vorzugsweise zumindest im Wesentlichen in einer gemeinsamen Ebene angeordnet, wobei diese Ebene besonders bevorzugt parallel zu der Erstreckungsebene der Sputterquellen 3 bzw. Targets 4 bzw. Drehachsen D verläuft.

Mit der vorschlagsgemäßen Vorrichtung 1 bzw. dem vorschlagsgemäßen Verfahren bzw. der vorschlagsgemäßen Verwendung von rohrförmigen, parallelen Targets 4 zur Beschichtung von Linsen 2 werden vorzugsweise Beschichtungsraten von 0,001 bzw. 20 nm/s, insbesondere 0,005 nm/s bis 2,5 nm/s, erreicht.

Die Drehgeschwindigkeit der Linse 2 beträgt vorzugsweise 10 bis 200 U/min., insbesondere etwa 40 bis 120 U/min.

Der Durchmesser der Linsen 2 beträgt vorzugsweise etwa 40 bis 85 mm.

Die Drehgeschwindigkeit der Targets 4 beträgt vorzugsweise etwa 3 bis 30 U/min.

Vorzugsweise ist die Drehgeschwindigkeit der Linsen 2 größer als die der Targets 4, insbesondere beträgt diese mehr als 2- oder 3-fache der Drehgeschwindigkeit der Targets 4.

Die Beschichtungszeit beträgt vorzugsweise etwa 4 bis 7 min.

Die vorschlagsgemäße Vorrichtung 1 bzw. das vorschlagsgemäße Verfahren bzw. die vorschlagsgemäße Verwendung wird vorzugsweise zum Aufbringen einer oder mehrerer Antireflexschichten verwendet.

Vorschlagsgemäß erfolgt insbesondere ein reaktives Beschichten, wobei durch entsprechende Zuführung von Reaktiv-Gas, beispielsweise von Stickstoff, Wasserstoff und/oder Sauerstoff, zum Arbeits-Gas (Edelgas), insbesondere Argon, das Targetmaterial damit reagieren und eine gewünschte Beschichtung auf der Linse 2 bilden kann.

Beim Beschichten wird die Vorrichtung 1 bzw. die Beschichtungskammer 7 vorzugsweise auf einen Druck von etwa 0,005 Pa bis 0,5 Pa evakuiert.

Es werden insbesondere eine Vorrichtung 1, ein Verfahren und eine Verwendung zur Beschichtung von Linsen 2 vorgeschlagen, wobei die zu beschichtenden Linsen paarweise über parallelen, rohrförmigen Targets 4 derart angeordnet werden, dass diese jeweils sowohl einen homogenen als auch einen inhomogenen Abtragungsbereich B1, B2 des Targets 4 überdecken und wobei die Linsen 2 rotieren, so dass eine besonders gleichmäßige Beschichtung erreichbar ist.

Weitere Aspekte der vorliegenden Erfindung sind:
1. Vorrichtung (1) zur Beschichtung von Linsen (2) mittels Sputtern, insbesondere Magnetronsputtern,
   mit mindestens einem Target (4) und
   mit einem Träger (10) zur Halterung mindestens einer zu beschichtenden Linse (2),
   wobei das Target (4) länglich oder rohrförmig ausgebildet ist und wobei die Linse (2) um eine zentrische bzw. die Linse (2) schneidende Achse (A) rotierbar ist,
   **dadurch gekennzeichnet,**
   dass die Achse (A) relativ zu dem Target (4) stationär ist, und/oder
   dass die Linse (2) sowohl in einem in Längserstreckung (L) des Targets (4) zumindest im Wesentlichen homogenen, nämlich um weniger als 5 % variierenden Bereich (B1) als auch in einem in Längserstreckung (L) des Targets (4) inhomogenen Bereich (B2) eines bei der Beschichtung auftretenden Ratenprofils (P) der Abtragung am zugeordneten Target (4) angeordnet und relativ zu dem Target (4) um die stationäre Achse (A) rotierbar ist, und/oder
   dass der Träger (10) zusammen mit mindestens zwei rotierbar gehaltenen Linsen (2) wechselbar ist, und/oder
   dass das Target (4) einen über die Längserstreckung (L) des Targets (4) variierenden Außendurchmesser aufweist, der insbesondere zu Enden des länglichen Targets (4) hin abnimmt.
2. Vorrichtung nach Aspekt 1, dadurch gekennzeichnet, dass die Linse (2) sowohl in einem ersten, zumindest im wesentlichen homogenen Bereich (B1) als auch in einem zweiten, inhomogenen Bereich (B2) ein Ratenprofils (P) der Abtragung des Targets (4) bei der Beschichtung angeordnet ist.
3. Vorrichtung nach Aspekt 1 oder 2, dadurch gekennzeichnet, dass die Linse (2) außermittig über dem Target (4) angeordnet ist.
4. Vorrichtung nach einem der voranstehenden Aspekte, dadurch gekennzeichnet, dass der Träger (10) die Linse (2) in einer stationären Position relativ zu dem Target (4) hält.
5. Vorrichtung nach einem der voranstehenden Aspekte, dadurch gekennzeichnet, dass zwei Linsen (2) symmetrisch bezüglich der Längserstreckung (L) des Targets (4) positioniert sind.
6. Vorrichtung nach einem der voranstehenden Aspekte, dadurch gekennzeichnet, dass der Träger (10) zwei Linsen (2) über entgegengesetzten Endbereichen des Targets (4) hält.
7. Vorrichtung nach einem der voranstehenden Aspekte, dadurch gekennzeichnet, dass das Target (4) drehbar ist.
8. Vorrichtung nach einem der voranstehenden Aspekte, dadurch gekennzeichnet, dass die Vorrichtung (1) zwei längliche bzw. rohrförmige Targets (4) aufweist, die parallel zueinander verlaufen und/oder abwechselnd als Kathode und Anode betreibbar sind.
9. Vorrichtung nach Aspekt 8, dadurch gekennzeichnet, dass vier Linsen (2) über den Targets (4) angeordnet sind bzw. werden, und zwar jeweils zwei Linsen (2) über einem Target (4).
10. Vorrichtung nach einem der voranstehenden Aspekte 8 oder 9, dadurch gekennzeichnet, dass die Achse(n) (A) der Linse(n) (2) quer oder senkrecht zu der Targetebene bzw. gemeinsamen Ebene der Targets (4) verläuft bzw. verlaufen.
11. Vorrichtung nach einem der voranstehenden Aspekte, dadurch gekennzeichnet, dass der Träger (10) mehrere Linsen (2) drehbar gekoppelt hält.
12. Vorrichtung nach einem der voranstehenden Aspekte, dadurch gekennzeichnet, dass der Träger (10) zur Halterung mehrerer Linsen (2) ausgebildet ist, wobei die Linsen (2) um eigene Achsen (A) rotierbar sind.
13. Vorrichtung nach einem der voranstehenden Aspekte, dadurch gekennzeichnet, dass die Vorrichtung (1) derart ausgebildet ist, dass der Träger (10) beim Einsetzen oder Einschieben in die Vorrichtung (1) bzw. deren Beschichtungskammer (7) automatisch antriebsmäßig oder getriebemäßig mit einem Antrieb (11) der Vorrichtung (1) koppelbar ist oder gekoppelt wird.
14. Vorrichtung nach einem der voranstehenden Aspekte, dadurch gekennzeichnet, dass der Träger (10) die Linse (2) mit stationärem Schwerpunkt bzw. zentrisch drehbar hält.
15. Vorrichtung nach einem der voranstehenden Aspekte, dadurch gekennzeichnet, dass die Achse (A) der Linse (2) das zugeordnete Target (4) schneidet.
16. Verfahren zur Beschichtung von gekrümmten Oberflächen von Linsen (2) mittels Sputtern, insbesondere Magnetronsputtern, eines Targets (4),
   wobei beim Beschichten bzw. Zerstäuben ein Ratenprofil (P) der Abtragung eines Targets (4) in einer Längserstreckung (L) des vorzugsweise länglichen oder rohrförmigen Targets (4) erzeugt wird und das Ratenprofil (P) einen ersten, zumindest im wesentlichen homogenen, nämlich um weniger als 5 % variierenden Bereich (B1) als auch einen zweiten, inhomogenen Bereich (B2) aufweist,
   **dadurch gekennzeichnet,**
   dass eine zu beschichtende Linse (2) sowohl in dem ersten als auch in dem zweiten Bereich (B1, B2) gehalten und dabei um eine stationäre Achse (A) rotiert wird.
17. Verfahren nach Aspekt 16, dadurch gekennzeichnet, dass die Linsen (2) paarweise beschichtet werden.
18. Verwendung von zwei rohrförmigen, parallelen Targets (4) zur Beschichtung von gekrümmten Oberflächen von Linsen (2) mittels Sputtern, insbesondere Magnetronsputtern,
   **dadurch gekennzeichnet,**
   dass vier Linsen (2) paarweise über den beiden Targets (4) angeordnet werden und um eigene Achsen (A) rotieren.
19. Verwendung nach Aspekt 18, dadurch gekennzeichnet, dass die Targets (4) abwechselnd als Kathode und Anode betrieben und/oder im gegenseitigen Wechsel mit Gleichstrom betrieben werden.
20. Verwendung eines im Wesentlichen rohrförmigen oder länglichen Targets (4) zur Beschichtung von gekrümmten Oberflächen von Linsen (2) mittels Sputtern, insbesondere Magnetronsputtern,
   **dadurch gekennzeichnet,**
   dass ein Target (4) mit einem über die Längserstreckung (L) des Targets (4) variirenden Außendurchmesser eingesetzt und insbesondere rotiert wird, insbesondere um ein gewünschtes, besonders bevorzugt zumindest im Wesentlichen homogenes, Ratenprofil (P) der Abtragung des Targets (4) in der Längserstreckung (L) und/oder eine gleichmäßige Beschichtung auf der Linse (2) zu erreichen.

### Bezugszeichenliste:

- 1: Vorrichtung
- 2: Linse
- 3: Sputterquelle
- 4: Target
- 5: Magnetanordnung
- 6: Spannungsquelle
- 7: Beschichtungskammer
- 8: Einrichtung
- 9: Gaszuführung
- 10: Träger

- A: Rotationsachse der Linse
- B1: erster Bereich
- B2: zweiter Bereich
- D: Drehachse des Targets
- E: Abstand Linsenachse-Targetende
- H: Hauptrichtung
- L: Längserstreckung bzw. Länge des Targets
- M: Mittelebene
- N: Neigungswinkel
- P: Ratenprofil
- S: Sputterwolke
- T: Targetoberfläche
- V: Abstand Linsenachse-Targetachse
- W: Winkel
- Z: Abstand Linse-Target

## Patentansprüche

1. Vorrichtung (1) zur Beschichtung von Linsen (2) mittels Sputtern,
mit mindestens einem Target (4) und
mit einem Träger (10) zur Halterung mindestens einer zu beschichtenden Linse (2),
wobei das Target (4) länglich oder rohrförmig ausgebildet ist und wobei die Linse (2) um eine zentrische bzw. die Linse (2) schneidende Achse (A) rotierbar ist,
**dadurch gekennzeichnet,**
**dass** das Target (4) einen über die Längserstreckung (L) des Targets (4) variierenden Außendurchmesser aufweist.

2. Vorrichtung nach Anspruch 1, **dadurch gekennzeichnet, dass** das Target (4) in der Mitte dicker als an den Endbereichen und/oder bauchig ausgebildet ist, und/oder dass der Außendurchmesser zu den Enden des länglichen Targets (4) hin abnimmt und/oder in Längserstreckung (L) einen konvexen, konkaven oder gewellten Verlauf aufweist.

3. Vorrichtung nach Anspruch 1 oder 2, **dadurch gekennzeichnet, dass** der Au-βendurchmesser des Targets (4) über die Längserstreckung (L) des Targets (4) um mehr als 4 % variiert, und/oder dass der Außendurchmesser in der Mitte um mehr als 4 % größer als an den Enden des Targets (4) ist.

4. Vorrichtung nach einem der voranstehenden Ansprüche, **dadurch gekennzeichnet, dass** der Außendurchmesser nur zu den Endbereichen des Targets (4) hin, insbesondere nur im Endbereich von weniger als 25 % der Länge (L) des Targets (4), jeweils reduziert ist bzw. abnimmt.

5. Vorrichtung nach einem der voranstehenden Ansprüche, **dadurch gekennzeichnet, dass** die Vorrichtung (1) eine Magnetanordnung (5) aufweist, die dem Target (4) zur Erzeugung eines Magnetfelds zugeordnet ist, insbesondere wobei das Magnetfeld bzw. die Magnetfeldstärke der Magnetanordnung (5) über die Längserstreckung (L) des Targets (4) variiert.

6. Vorrichtung nach einem der voranstehenden Ansprüche, **dadurch gekennzeichnet, dass** die Linse (2) außermittig und/oder in einem Endbereich über dem Target (4) angeordnet ist.

7. Vorrichtung nach einem der voranstehenden Ansprüche, **dadurch gekennzeichnet, dass** der Träger (10) die Linse (2) in einer stationären Position relativ zu dem Target (4) und/oder mit stationärem Schwerpunkt und/oder zentrisch drehbar hält.

8. Vorrichtung nach einem der voranstehenden Ansprüche, **dadurch gekennzeichnet, dass** zwei Linsen (2) symmetrisch bezüglich der Längserstreckung (L) des Targets (4) positioniert sind, und/oder dass der Träger (10) zwei Linsen (2) über entgegengesetzten Endbereichen des Targets (4) hält.

9. Vorrichtung nach einem der voranstehenden Ansprüche, **dadurch gekennzeichnet, dass** das Target (4) drehbar ist.

10. Vorrichtung nach einem der voranstehenden Ansprüche, **dadurch gekennzeichnet, dass** die Vorrichtung (1) zwei längliche bzw. rohrförmige Targets (4) aufweist, die parallel zueinander verlaufen und/oder abwechselnd als Kathode und Anode betreibbar sind.

11. Vorrichtung nach Anspruch 10, **dadurch gekennzeichnet, dass** vier Linsen (2) über den Targets (4) angeordnet sind bzw. werden, und zwar jeweils zwei Linsen (2) über einem Target (4), und/oder dass die Achse(n) (A) der Linse(n) (2) quer oder senkrecht zu der Targetebene bzw. gemeinsamen Ebene der Targets (4) verläuft bzw. verlaufen.

12. Verwendung eines rohrförmigen oder länglichen Targets (4) zur Beschichtung von gekrümmten Oberflächen von Linsen (2) mittels Sputtern,
**dadurch gekennzeichnet,**
**dass** ein Target (4) mit einem über die Längserstreckung (L) des Targets (4) variirenden Außendurchmesser eingesetzt wird.

13. Verwendung nach Anspruch 12, **dadurch gekennzeichnet, dass** das Target (4) rotiert wird.

14. Verwendung nach Anspruch 12 oder 13, **gekennzeichnet durch** die Verwendung des Targets (4) zum Erreichen eines gewünschten, besonders bevorzugt zumindest im Wesentlichen homogenen, Ratenprofils (P) der Abtragung des Targets (4) in der Längserstreckung (L) und/oder einer gleichmäßigen Beschichtung auf der Linse (2).

15. Verwendung nach einem der Ansprüche 12 bis 14, **gekennzeichnet durch** die Verwendung einer Vorrichtung nach einem der Ansprüche 1 bis 11.
